# EUROPEAN PATENT APPLICATION

(11) **EP 2 020 838 A2**
(43) Date of publication of application: **04.02.2009**
(21) Application number: 08013483.6
(22) Date of filing: 25.07.2008
(51) Int. Cl.: H05K 13/04, H05K 13/08

(54) **Electronic component mounting apparatus and a method of mounting an electronic component on a board**

(30) Priority: 31.07.2007 JP 2007199787
(71) Applicant: Hitachi High-Tech Instruments Company, Ltd., Kumagaya-shi Saitama 360-0238 (JP)
(72) Inventor: Kawabata, Yoshihiro, Isesaki-shi, Gunma (JP); Katsuta, Shigeo, Ora-gun, Gunma (JP); Izuhara, Koichi, Ora-gun, Gunma (JP); Watanabe, Akio, Ota-shi, Gunma (JP); Wada, Toshiaki, Ora-gun, Gunma (JP)
(74) Representative: Glawe, Delfs, Moll

(57) **Abstract**

The invention is directed to manufacturing a divided board without wasting an electronic component by judging whether or not a shortage of electronic components (5) of a given type to be mounted on divided board portions will occur during the mounting before mounting electronic components on the divided board (6). A printed board (6) having three board portions is carried onto an XY table from a supply conveyer and positioned by positioning means. Then, for each of component feeding units, a CPU judges whether or not the number of remaining electronic components (5) is smaller than the number of necessary electronic components for manufacturing all the divided board portions. When the number is judged smaller, for example, when the number of remaining electronic components of Fdr. No. "102" is judged to be two that is less than three, the CPU calculates that the number of manufacturable divided board portions is two. The CPU then decides that the divided board portions on the left side and in the middle are to be manufactured, adds "S" to a skip code space of a step number 3 for the third divided board portion, and manufactures only the divided board portions not given "S".

## Description

### CROSS-REFERENCE OF THE INVENTION

This application claims priority from Japanese Patent Application No. 2007-199787, the content of which is incorporated herein by reference in its entirety.

### BACKGROUND OF THE INVENTION

### Field of the Invention:

The invention relates to an electronic component mounting apparatus for mounting electronic components picked up from component feeding units on a plurality of divided board portions of a divided board.

### Description of the Related Art:

Conventionally, in this type of electronic component mounting apparatus, which is disclosed in, for example, Japanese Patent Application Publication No. 2003-17900, when electronic components are mounted on a plurality of divided board portions of a divided board, in a case where a shortage of the electronic components occurs during the mounting on the divided board portions of the divided board, the apparatus generally stops the mounting operation at the time when the shortage occurs. However, this causes a problem where the electronic components which are not in shortage are already mounted on the divided board portions having the shortage of the electronic components.

In this case, when the apparatus stops the mounting operation at the time when the shortage occurs, this may provide an uncompleted product where all components are not mounted on each of divided board portions or the divided board where the only electronic components in shortage are not mounted.

In both the cases, the uncompleted divided board portion is wasted, which is a problem in manufacturing the divided board.

It is an object at the present invention to provide an improved manufacturing that lessens this drawback.

### SUMMARY OF THE INVENTION

The solution according to the invention resides in the features of the independent claims, and preferably in those of the dependent claims. The invention is directed to manufacturing a divided board without wasting an electronic component by judging whether or not a shortage of electronic components of a given type to be mounted on divided board portions of a divided board will occur during the mounting before starting mounting electronic components on the divided board.

The invention provides an electronic component mounting apparatus that includes a component feeding unit feeding an electronic component to a feeding position, a suction nozzle picking up the electronic component from the feeding position and mounting the picked up electronic component on a board having a plurality of divided board portions, and a computing device determining whether or not a shortage of an electronic component of a given type to be mounted on the board occurs during the mounting of the electronic component of the given type on all of the divided board portions of the board before starting the mounting. The computing device controls the suction nozzle so that no electronic component is mounted on one of the divided board portions of the board when the computing device determines that the shortage of the electronic component of the given type occurs and that the electronic component of the given type is mounted on all of the divided board portions of the board when the computing device determines that the shortage of the electronic component of the given type does not occur.

The invention also provides a method of mounting an electronic component on a board. The method includes providing a board having a plurality of divided board portions, determining whether there is enough electronic components of a given type to complete mounting on all of the divided board portions of the board, and mounting no electronic component on one of the divided board portions of the board when it is determined that there is not enough electronic components of the given type and mounting electronic components, including the electronic components of the given type, to complete mounting of all of the divided board portions of the board when it is determined that there is enough electronic components of the given type.

### BRIEF DESCRIPTION OF THE DRAWINGS

Fig. 1 is a plan view of an electronic component mounting apparatus.
Fig. 2 is a cutaway side view of the electronic component mounting apparatus.
Fig. 3 is a control block diagram.
Fig. 4 is a table showing mounting data.
Fig. 5 is a table showing component disposition data.
Fig. 6 is a view showing a repetition pattern in which mounting is repeated in a normal sequence.
Fig. 7 is a flowchart.
Fig. 8 is a table showing mounting data for repeating mounting in a reverse sequence.
Fig. 9 is a view showing a repetition pattern in which mounting is repeated in the reverse sequence.
Fig. 10 is a table showing mounting data for repeating mounting in a mixed sequence of the normal and reverse sequences.
Fig. 11 is a view showing a repetition pattern in which mounting is repeated in the mixed sequence of the normal and reverse sequences.

### DETAILED DESCRIPTION OF THE INVENTION

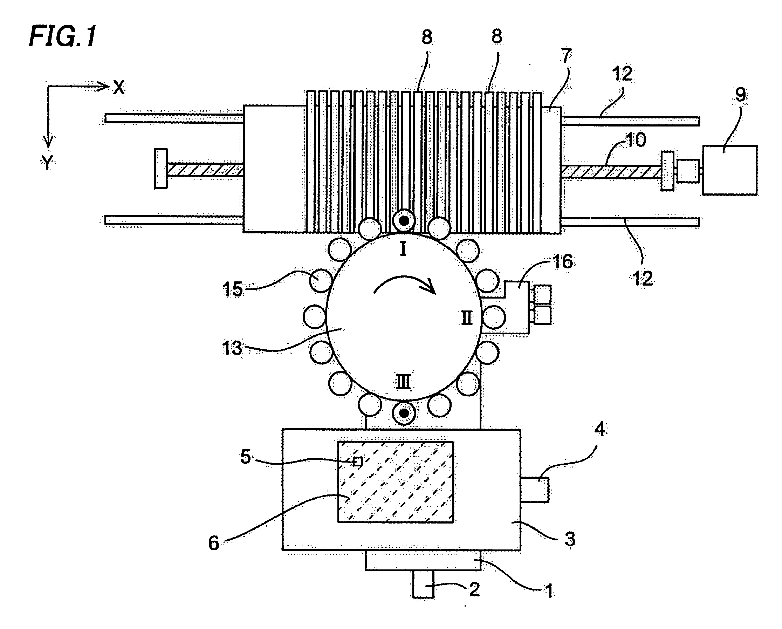

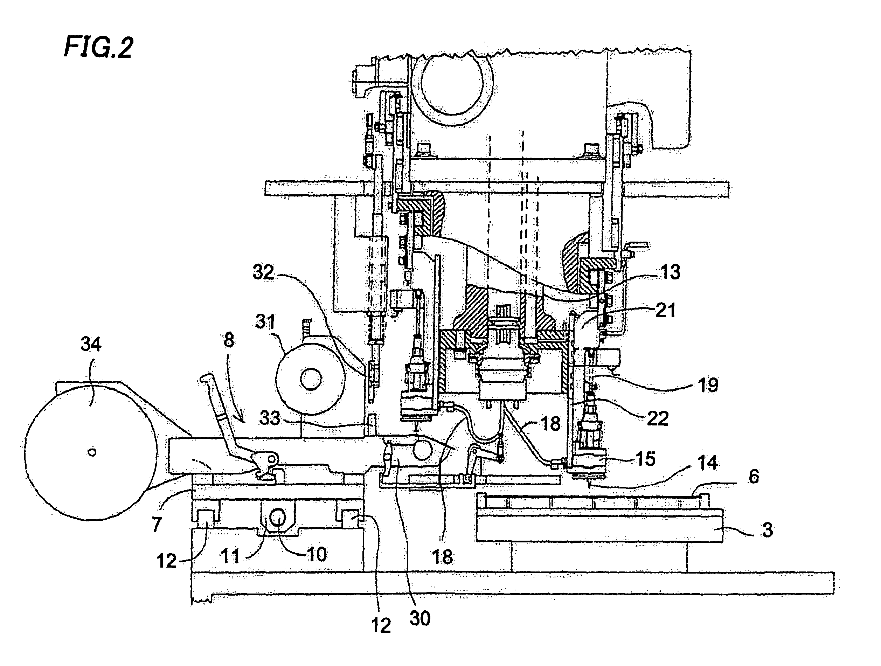

An embodiment of the invention will be described referring to figures. In Figs. 1 and 2, a numeral 1 designates a Y table moving in a Y direction driven by a Y axis motor 2, and a numeral 3 designates an XY table moving in X and Y directions by moving in the X direction on the Y table 1 driven by an X axis motor 4, on which a printed board 6 where a chip-type electronic component 5 (hereafter, referred to as "an electronic component" or "a component") is to be mounted is fixed by positioning fixing device (not shown). In this electronic component mounting apparatus, a supply conveyer is provided in the upstream position from the XY table 3 and a discharge conveyer is provided in the downstream position therefrom.

A numeral 7 designates a feeding stage which is provided with many component feeding units 8 for feeding the electronic components 5. A numeral 9 designates a feeding stage drive motor which rotates a ball screw 10 to move the feeding stage 7 in the X direction along linear guides 12 through a nut 11 engaged with the ball screw 10 and fixed to the feeding stage 7. A numeral 13 designates a rotary table intermittently rotating itself. On the outer edge of the table 13, mounting heads 15 having a plurality of suction nozzles 14 are provided at predetermined intervals corresponding to intermittent pitches.
A pickup station I lies in a position where the mounting head 15 having the suction nozzles 14 for picking up the components 5 by suction from the feeding units 8 stops when the rotary table 13 stops during intermittent rotation. At the pickup station I, the mounting head 15 descends and the suction nozzles 14 pick up the components 5 by suction.

II designates a recognition station where the mounting head 15 holding the components 5 by suction stops during the intermittent rotation of the rotary table 13, a component recognition camera 16 takes images of the components 5, and positional shifts of the components 5 from normal positions on the suction nozzles 14 are recognized.

III designates a mounting station (in the position given a filled circle on the lower side in Fig. 1) where the mounting head 15 stops so that the suction nozzles 14 mount the held components 5 on the printed board 6. At this mounting station III, the mounting head 15 descends, and the components 5 are mounted on the printed board 6 resting at a predetermined position by moving of the XY table 3.

A numeral 18 designates a cable including a power line for sending a current from a drive circuit 41 stored in the rotary table 13 for driving a θ axis motor 40 provided in the mounting head 15 and having a pulse motor for the suction nozzles 14, a power line for sending a current to a vacuum valve, a wire for sending and flowing a current to other current drive loads and so on, and this is connected to each of the mounting heads 15. A numeral 19 designates a vacuum tube connected to a vacuum source (not shown) in order to pick up the electronic components 5 by the suction nozzles 14. The mounting head 15 is attached to a linear guide 22 through a head block 21, being movable upward and downward relative to the rotary table 13.

The component feeding unit 8 includes a tape reel 34 around which a storage tape (not shown) for feeding electronic components is wound, a tape advancing device 30 for advancing the storage tape from the tape reel 34, a winding reel 31 for winding a cover tape from a carrier tape of the storage tape. The storage tape includes the carrier tape storing the electronic components in its component storage pocket portions formed at equal interval pitches and having many sprocket holes on the side, and the cover tape.

A numeral 32 designates a tape advancing drive lever moving upward and downward for moving a drive lever 33 of the tape advancing device 30 upward and downward, forming a structure in which the tape advancing drive lever 32 is driven in synchronization with the rotary table 13 to move upward and downward and intermittently advance the storage tape wound around the tape reel 34, feeds the electronic component 5 stored in the component storage pocket portion of the carrier tape from which the cover tape is removed to the pickup position for the suction nozzle 14 so that the descending suction nozzle 14 picks up the component by suction, as described below in detail.

Although not shown, the winding reel 31 for winding the cover tape is also driven by the tape advancing drive lever 32 in synchronization with the rotary table 13, in the same manner as the tape advancing device 30.

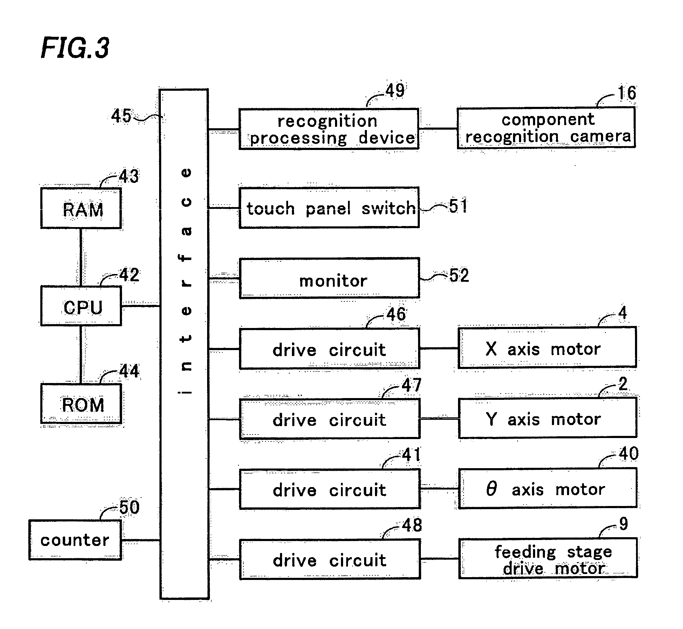

Next, a control block diagram will be described referring to Fig. 3, and the description will be given by showing only one of the θ axis motors 40 each provided for each of the mounting heads 15 for convenience. A numeral 42 designates a CPU (central processing unit) as a control portion for controlling the operation of mounting the electronic components of the mounting apparatus 1, a numeral 43 designates a RAM (random access memory) as a memory, and a numeral 44 designates a ROM (read only memory). The CPU 42 controls each of the drive sources through an interface 45 for the component mounting operation of the electronic component mounting apparatus based on data stored in the RAM 43 and according to programs stored in the ROM 44.
In detail, the CPU 42 controls the driving of the X axis motor 4 through the drive circuit 46, the driving of the Y axis motor 2 through the drive circuit 47, the driving of the θ axis motor 40 through the drive circuit 41, and further the driving of the feeding stage drive motor 9 through the drive circuit 48.

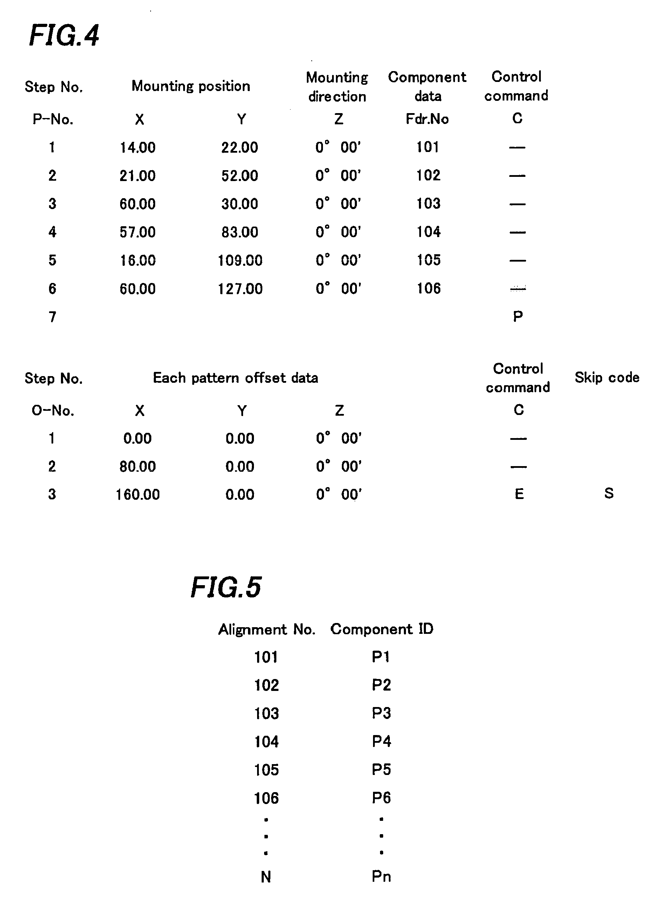

As shown in Fig. 4, the RAM 43 is stored with mounting data and each pattern offset data including mounting positions in the X and Y directions and mounting directions (angles) on the printed board 6 and Fdr. No. data (the alignment numbers of the component feeding units 8) and so on in the order of mounting electronic components, and also stored with component disposition data as shown in Fig. 5, i.e., component ID (the types of the electronic components) for each of the alignment numbers of the component feeding units 8 (corresponding to the positions on the feeding stage 7).

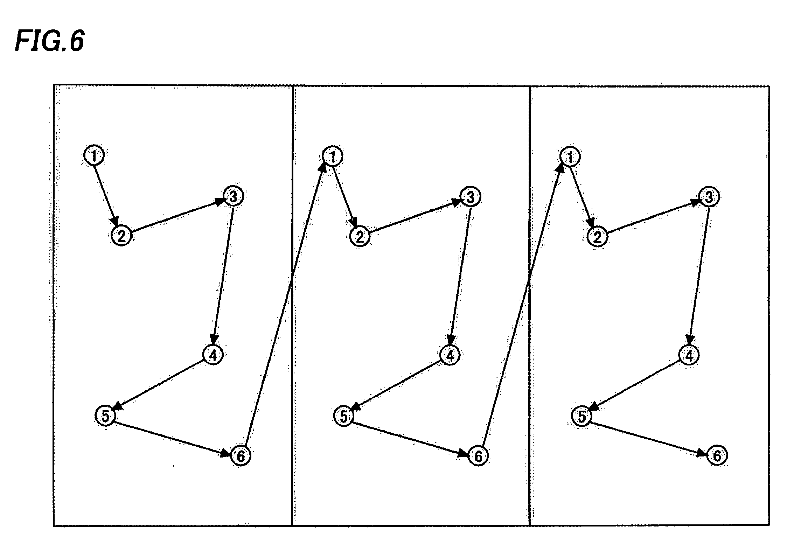

It is noted that the printed board 6 is a divided board where electronic components are mounted in a repetition pattern and the pattern offset data indicates the position and direction of the mounting pattern to be formed on the divided board according to the mounting data.
Specifically, in the embodiments of the invention, a printed board 6 includes divided board portions, each of which has the same mounting pattern, as shown in Figs. 6, 9 and 11. It is noted that the divided portions do not have to be physically separated.

A numeral 49 designates a recognition processing device connected with the CPU 42 through the interface 45. The recognition processing device 49 performs recognition processing to images taken and stored by the component recognition camera 16, and sends a recognition result to the CPU 42. That is, the CPU 42 outputs a command to perform recognition processing (e.g. calculation of a shifting amount of an electronic component from a normal position) to images taken by the component recognition camera 16 to the recognition processing device 49, and receives a recognition processing result from the recognition processing device 49.

That is, when the recognition processing device 49 performs recognition processing and detects a shifting amount from a normal position, this recognition result is sent to the CPU 42. Then, the CPU 42 moves the XY table 3 in the Y and X directions by driving the Y axis motor 2 and the X axis motor 4 and rotates the suction nozzle 14 by an angle θ by driving the θ axis motor 40, thereby completing correction in the X and Y directions and the rotating angle around the vertical axis.

The image taken by the component recognition camera 16 is displayed on a monitor 52 as a display device. The monitor 52 is provided with a variety of touch panel switches 51, and various settings including settings for informing are made by an operator's operating the touch panel switches 51.

Feeder data (serial numbers specific to the component feeding units 5 respectively) including a bar code given to a label attached to a predetermined position of the component feeding unit 8, e.g., a handle used for mounting the component feeding unit 8 on the feeding stage 7 or dismounting it therefrom, or component data (the component ID as the name of the electronic component and the number of the stored electronic components) including a bar code given to a label attached to the tape reel 34 around which the storage tape is wound and stored are read out by, for example, a bar code scanner, and stored in the RAM 43. Furthermore, each of the counters 50 subtracts "1" from the number of the stored electronic components each time an electronic component is fed from each of the component feeding units 8, and keeps track of the number of remaining electronic components for each of the component feeding units 8 all the time.

It is noted that only one of the counters 50 is shown for convenience although the counter 50 is provided for each of the component feeding units 8. Furthermore, the number of stored electronic components may be inputted and stored in the RAM 43 by operating the touch panel switches 51 displayed on the monitor 52.

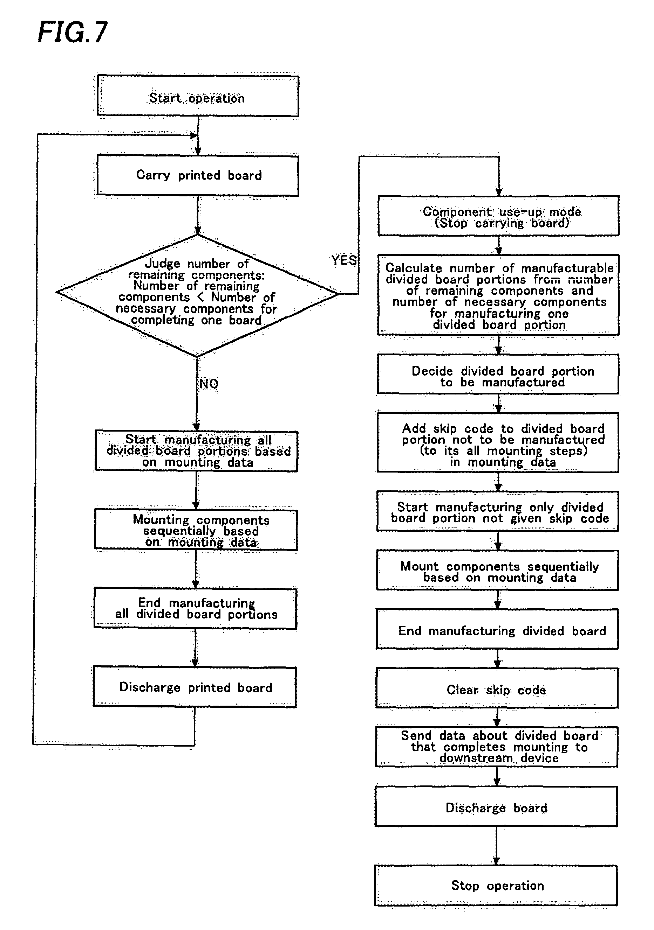

With the above structure, a description will be given particularly referring to a flow chart shown in Fig. 7. First, when an operator operates an operation start switch portion of the touch panel switches 51 displayed on the monitor 52, the CPU 42 takes control to start the operation of mounting the electronic components.

Then, a printed board 6 which is a divided board having three board portions placed on the supply conveyer is carried from the upstream device onto the XY table 3, and positioned and fixed by the positioning device. Then, the CPU 42 judges the number of remaining electronic components. In detail, the CPU 42 judges whether or not the number of the remaining stored electronic components is smaller than the number of electronic components necessary for manufacturing one printed board 6, i.e., all the divided board portions, for each of the component feeding units 8 storing the electronic components to be mounted on the printed board 6 based on the mounting data.

At this time, when the CPU 42 judges that the number of the remaining stored electronic components is not smaller than the number of the necessary electronic components for manufacturing one printed board, i.e., that there is the necessary number of the electronic components for manufacturing all the divided board portions, the CPU 42 starts the manufacturing process for all the divided board portions of the printed board 6 based on the mounting data. In this case, based on the mounting data for the printed board 6 which is the divided board, the electronic components 5 are sequentially mounted on the printed board 6.
To describe the mounting operation in detail, the tape advancing drive lever 32 descends being driven in synchronization with the rotary table 13 and thus the drive lever 33 of the tape advancing device 30 descends to intermittently advance the storage tape wound around the tape reel 34. The electronic component 5 stored in the storage pocket portion of the carrier tape is thus fed to the position where the component 5 is to be picked up by the suction nozzle 14 and simultaneously the cover tape is removed, the component 5 is picked up by suction by the descending suction nozzle 14, and the cover tape is wound around the winding reel 31.

When the mounting head 15 stops at the pickup station I during the intermittent rotation of the rotary table 13 through an index system, the feeding stage drive motor 9 is driven to move the feeding stage 7, and the component feeding unit 8 storing the electronic component 5 to be fed moves to and stops at the pickup position for the suction nozzle 14 of the mounting head 15 at the pickup station I. The suction nozzle 14 then descends to pick up the electronic component 5.

Then, while the rotary table 13 intermittently rotates, the mounting head 15 holding the electronic components 5 moves to and stops at the next station. The rotary table 13 further rotates, and the mounting head 15 moves to and stops at the recognition station II. Then, the component recognition camera 16 takes images of the electronic components 5 held by suction by the suction nozzles 14 and the recognition processing device 49 recognizes the images, so that the positional shift of each of the components 5 from a normal position on each of the suction nozzles 14 is recognized.

Then, when completing the recognition processing, the CPU 42 calculates an angle amount by adding an amount to be corrected calculated by using a result of the recognition to the mounting angle data in the mounting data. The θ axis motor 40 rotates to achieve this angle and simultaneously the rotary table 13 intermittently rotates to move the mounting head 15 to the mounting station III. The electronic component 5 positioned at the angle is mounted on the printed board 6 positioned on the coordinates indicated in the mounting data by the movement of the XY table 3.

Electronic components are thus sequentially mounted on the printed board 6. When the divided board portions of the printed board 6 are completed, the printed board 6 on the XY table 3 is carried to the downstream device through the discharge conveyer, and the next printed board 6 is carried from the supply conveyer to start the electronic component mounting operation as described above.

Each time when an electronic component is fed from each of the component feeding units 8, each of the counters 50 subtracts "1" from the number of stored electronic components in each of the component feeding units 8, and the number of remaining electronic components in each of the component feeding units 8 is thus kep track of all the time. When the CPU 42 judges that the number of the remaining electronic components stored in each of the component feeding units 8 is smaller than the number of necessary electronic components for manufacturing all divided board portions of one printed board 6, the following process is performed.

First, the CPU 42 takes control to switch to a component use-up mode, and stops carrying the printed board 6 from the upstream device. Then, the CPU 42 calculates the number of manufacturable divided board portions from the number of the remaining electronic components and the number of necessary electronic components for manufacturing one divided board portion. At this time, in a case of mounting the electronic components in a repetition pattern in which the mounting is repeated on three divided board portions in a normal sequence as shown in Fig. 6 according to the mounting data as shown in Fig. 4 ("P" is inputted to the control command at the step number 7), when the number of remaining electronic components of, for example, Fdr. No. "102" which are particularly specified components becomes two which is less than three, the CPU 42 determines that the number of the manufacturable divided board portions is two.

Then, the CPU 42 decides that the divided board portions on the left side and in the middle in Fig. 6 are to be manufactured, adds "S" to a skip code space of the step number 3 for the divided board portion not to be manufactured (the divided board portion on the right side in Fig. 6) in the mounting data (on the lower right side in Fig. 4), and starts manufacturing only the divided board portions not given "S" on the left side and in the middle in Fig. 6 without mounting an electronic component on the divided board portion on the right side in Fig. 6.

In this case, steps of mounting the electronic components on the printed board 6 are developed based on each pattern offset data, and in the developed steps "S" is given to the skip code space of the step for the divided board portion for skipping the mounting.

Then, the electronic component mounting operation is performed as described above, and the electronic components 5 are sequentially mounted on the two divided board portions of the printed board 6 (the divided board portions on the left side and in the middle in Fig. 6) based on the mounting data. When the divided board portions on the left side and in the middle of this printed board 6 in Fig. 6 are completed, the CPU 42 clears "S" in the skip code space for skipping the electronic component 5 in the mounting data stored in the RAM 43, and sends divided board data about the divided board portions completing the mounting (data about which divided board portions the electronic components are mounted or not mounted on) to a downstream device through a send/receive circuit (not shown) and a send/receive line.

Therefore, the downstream device receiving this divided board data performs a process of manufacturing the printed board 6 based on this divided board data accordingly. In detail, when the downstream device is an electronic component mounting apparatus, for example, the apparatus performs a process such that electronic components 5 are mounted on the divided board portions on the left side and in the middle in Fig. 6 and are not mounted on the divided board portion on the right side in Fig. 6.

Then, the printed board 6 on the XY table 3 is discharged to the downstream device through the discharge conveyer, and the CPU 42 takes control to stop the operation.

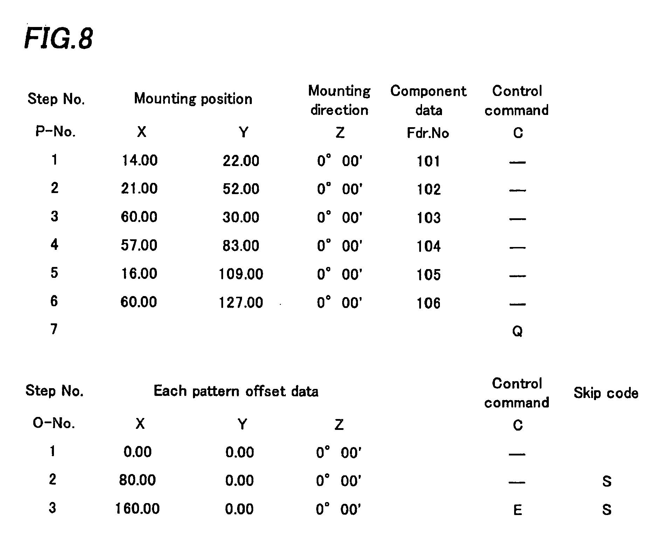

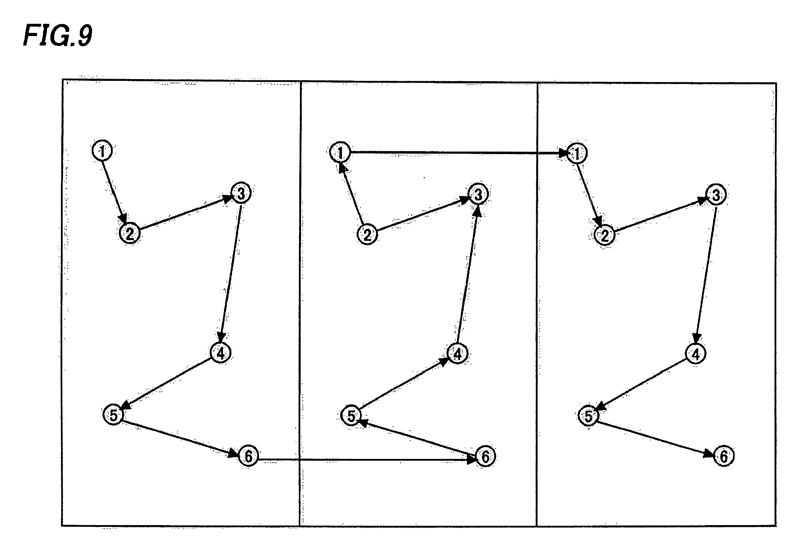

Furthermore, in a case of mounting the electronic components on the three divided board portions in a repetition pattern in which the mounting is repeated in a reverse sequence as shown in Fig. 8 ("Q" is inputted to the control command of the step number 7), the CPU 42 calculates the number of manufacturable divided board portions from the number of remaining electronic components and the number of necessary electronic components for manufacturing one divided board portion. When the number of remaining electronic components of, for example, Fdr. No. "102" which are particularly specified components becomes one which is less than three, the CPU 42 calculates that the number of the manufacturable divided board portions is one. The CPU 42 then decides that only the divided board portion on the left side in Fig. 9 is to be manufactured, adds "S" to skip code spaces of the step numbers 2 and 3 for the divided board portions not to be manufactured (the divided board portions in the middle and on the right side in Fig. 9) in the mounting data (Fig. 8), and starts manufacturing only the divided board portion not given "S" (the divided board portion on the left side in Fig. 9).

In this case, steps of mounting the electronic components on the printed board 6 are developed based on each pattern offset data, and in the developed steps "S" is added to the skip code spaces of the steps for the divided board portions for skipping the mounting.

The above embodiment is described for application to the normal sequence (Fig. 6) in which the electronic components are mounted on the plurality of divided board portions of the divided board in the repetition pattern or to the reverse sequence (Fig. 9), but the invention is not limited to this and applicable to a mixed sequence of the normal and reverse sequences, that is, a case of using the different sequences for each of the types of the electronic components.

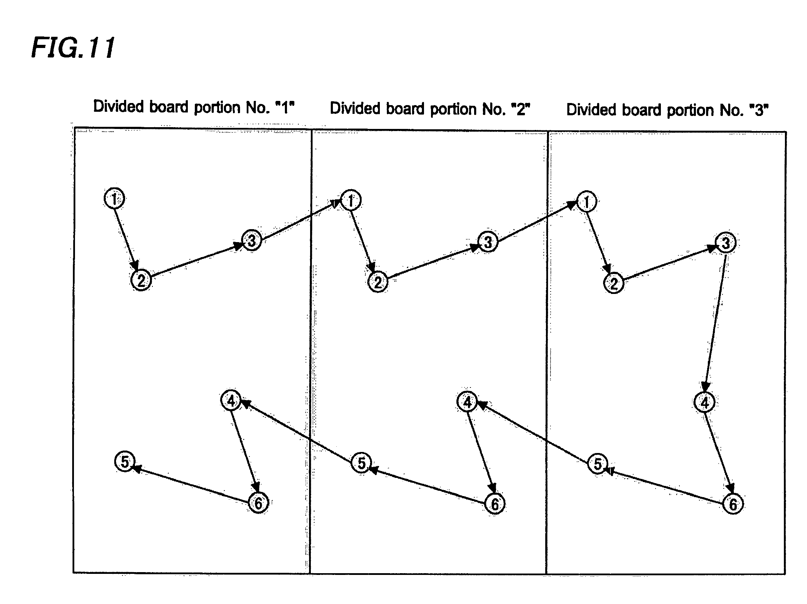

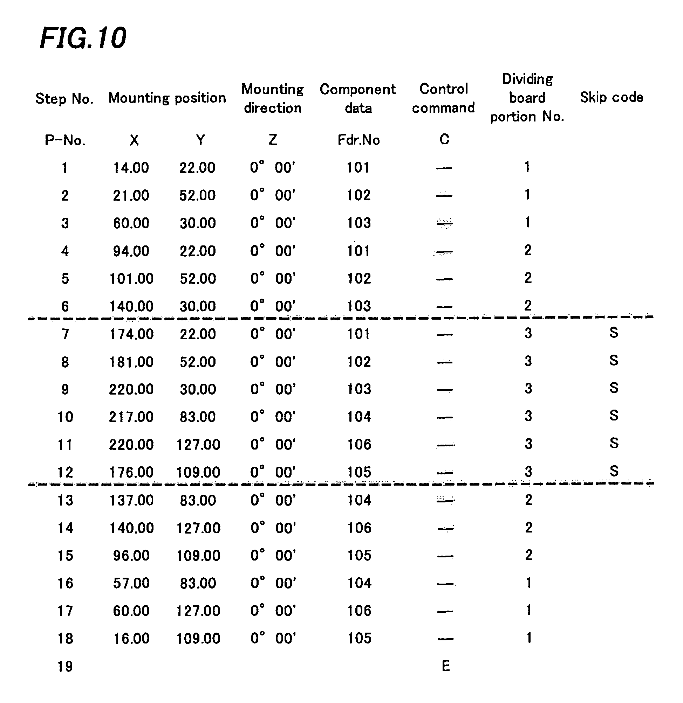

Hereafter, a description will be given based on mounting data developed into mounting data as shown in Fig. 10 for repeating the mounting in the normal sequence and the reverse sequence mixedly (divided board portion numbers are given for the step numbers respectively.) and Fig. 11 showing a repetition pattern in which the mounting is repeated.

In a case of mounting the electronic components on the three divided board portions in a repetition pattern in which the mounting is repeated in a mixed sequence of the normal and reverse sequences as shown in Fig. 11, the CPU 42 calculates the number of manufacturable divided board portions from the number of remaining electronic components and the number of necessary electronic components for manufacturing one divided board portion. When the number of remaining electronic components of, for example, Fdr.

No. "104" which are particularly specified components becomes two which is less than three, the CPU 42 calculates that the number of the manufacturable divided board portions is two. The CPU 42 decides that the divided board portions on the left side and in the middle in Fig. 11 are to be manufactured (the divided board portion numbers "1" and "2"), adds "S" to skip code spaces of the step numbers 7 to 12 for the divided board portion not to be manufactured (the divided board portion on the right side in Fig. 11 having the divided board portion number "3") in the mounting data, and starts manufacturing only the divided board portions not given "S" (the divided board portions on the left side and in the middle in Fig. 11).

In the case of mounting the electronic components in the repetition pattern in which the mounting is repeated in the normal sequence as shown in Fig. 4 or in the case of mounting the electronic components in the repetition pattern in which the mounting is repeated in the reverse sequence as shown in Fig. 8, too, the electronic components are mounted on the divided board portions based on mounting data developed into mounting data as shown in Fig. 10 (The divided board portion numbers are given for the step numbers respectively).

The above described control may be performed by keeping track of only the number of particular remaining electronic components or, without limited to this, by keeping track of the number of remaining electronic components of all types.

As described above, a divided board is manufactured without wasting an electronic component by judging whether or not a shortage of electronic components of a given type to be mounted on divided board portions of the divided board will occur during the mounting before starting mounting electronic components on the divided board.

Although the embodiment of the invention is described as above, various substitutions, modifications and variations based on the above description are possible for those skilled in the art, and the invention includes these various substitutions, modifications and variations within the scope of the invention.

## Claims

1. An electronic component mounting apparatus comprising:
a component feeding unit (8) feeding an electronic component (5) to a feeding position;
a suction nozzle (14) picking up the electronic component from the feeding position and mounting the picked up electronic component (5) on a board (6) comprising a plurality of divided board portions; and
a computing device (42) determining whether or not a shortage of an electronic component (5) of a given type to be mounted on the board (6) occurs during the mounting of the electronic component (5) of the given type on all of the divided board portions of the board (6) before starting the mounting,
wherein the computing device (42) controls the suction nozzle (14) so that no electronic component (5) is mounted on one of the divided board portions of the board (6) when the computing device (42) determines that the shortage of the electronic component (5) of the given type occurs and that the electronic component (5) of the given type is mounted on all of the divided board portions of the board (6) when the computing device (42) determines that the shortage of the electronic component (5) of the given type does not occur.

2. The electronic component mounting apparatus of claim 1, further comprising a counter (50) keeping track of the number of remaining electronic components (5) of the given type in the component feeding unit (8), wherein the computing device (42) uses the number of remaining electronic components (5) of the given type to determine the shortage.

3. A method of mounting an electronic component on a board, comprising:
providing a board (6) comprising a plurality of divided board portions;
determining whether there is enough electronic components (5) of a given type to complete mounting on all of the divided board portions of the board (6); and
mounting no electronic component (5) on one of the divided board portions of the board (6) when it is determined that there is not enough electronic components (5) of the given type, and mounting electronic components (5), including the electronic components (5) of the given type, to complete mounting of all of the divided board portions of the board (6) when it is determined that there is enough electronic components (5) of the given type.

4. The method of claim 3, further comprising mounting the electronic components (5) on the board (6) so that each of the divided board portions has the same pattern of mounted electronic components (5).

5. The method of claim 3 or 4, further comprising keeping track of the number of electronic components (5) of the given type remaining in a component feeding unit (8) and determining whether there is enough electronic components (5) of the given type based on the number of the remaining electronic components (5).
